# FASCICULE DE BREVET EUROPEEN

(11) **EP 3 758 180 B1**
(45) Date de publication et mention de la délivrance du brevet: **16.11.2022**
(21) Numéro de dépôt: 20181761.6
(22) Date de dépôt: 23.06.2020
(51) Int. Cl.: H02H 5/04, G01R 31/12, H01F 27/40, H01H 9/16, H01H 33/55, H02H 5/08, H02H 7/04

(54) **DISPOSITIF ET PROCÉDÉ DE PROTECTION ET/OU DE MONITORAGE POUR TRANSFORMATEUR ÉLECTRIQUE DU TYPE A DIÉLECTRIQUE LIQUIDE ENFERMÉ DANS UNE CUVE HERMÉTIQUE**
VORRICHTUNG UND VERFAHREN ZUM SCHUTZ UND/ODER ZUR ÜBERWACHUNG FÜR ELEKTRISCHEN TRANSFORMATOR VOM TYP MIT DIELEKTRISCHER FLÜSSIGKEIT, DIE IN EINEM HERMETISCH ABGESCHLOSSENEN TANK EINGESCHLOSSEN IST
DEVICE AND METHOD FOR PROTECTING AND/OR FOR MONITORING AN ELECTRICAL TRANSFORMER OF THE TYPE WITH LIQUID DIELECTRIC CONTAINED IN A SEALED TANK

(30) Priorité: 24.06.2019 FR 1906783; 11.07.2019 FR 1907810
(43) Date de publication de la demande: 30.12.2020
(60) Demande divisionnaire: 22163029.6
(73) Titulaire: IDEF Systemes, 74540 Saint-Felix (FR)
(72) Inventeur: PATERNOT, Frédéric, 1297 FOUNEX (CH); PLANTARD, Arbogaste, 74540 HERY-SUR-ALBY (FR); LAVAULT, Yves, 74960 CRAN GEVRIER (FR); LAVAULT, Carole, 38700 LA TRONCHE (FR); FOURNIER, Sylvain, 89120 CHARNY OREE DE PUSAYE (FR)
(74) Mandataire: IP Trust

(56) Documents cités:
- EP-A1- 2 682 972
- EP-A1- 3 032 553
- FR-A1- 2 746 555
- US-A- 4 654 806

## Description

### DOMAINE DE L'INVENTION

La présente invention concerne un dispositif de protection et de monitorage pour un transformateur électrique du type à diélectrique liquide enfermé dans une cuve hermétique.

### ARRIERE PLAN TECHNOLOGIQUE DE L'INVENTION

Les transformateurs électriques de distribution dans leur version hermétique à bain d'huile sont généralement équipés de relais de sécurité pilotant la disjonction par la fourniture de contacts électromécaniques. Ces contacts basculent en cas de surpression, de température trop élevée ou lorsque le niveau d'huile descend en dessous d'une valeur minimale. Ces fonctions de sécurité permettent d'éviter des situations extrêmes pouvant entraîner un risque d'explosion, d'incendie et/ou de dégradation importante des caractéristiques du transformateur.

Au-delà de ces fonctions indispensables, l'exploitation optimale des transformateurs de distribution présente bien d'autres exigences. Un suivi régulier de l'état du transformateur est nécessaire. Comme le rappelle le document EP3032553, ce suivi peut s'effectuer par l'analyse de l'huile, effectuée par prélèvement, en général une fois par an, sur site. Cette mesure est très importante, mais, par sa nature intégrante, elle ne permet pas d'avoir une idée précise du régime auquel a été soumis le transformateur en temps réel : surcharges, montée anormale en température ou les montées brutales de pression sans atteindre les seuils de basculement, traçabilité d'événements comme le basculement des contacts de sécurité, les chocs de foudre au primaire. Or ces événements peuvent impacter fortement la durée de vie consommée/résiduelle et conditionner des décisions de maintenance préventive ou de renouvellement. L'efficience énergétique de ces appareils prend une importance croissante, elle est souvent directement liée à la charge du transformateur et à son vieillissement. Le chiffrage des pertes et l'optimisation des performances sont importants pour obtenir une efficience maximale.

D'autre part, quand le basculement des contacts électromécaniques de sécurité intervient, des dégâts importants peuvent déjà avoir eu lieu au niveau des équipements alimentés, notamment lorsque la mise hors tension dure un certain temps. La mise hors tension imprévue peut également générer des pertes d'exploitation importantes. Il serait donc souhaitable de pouvoir anticiper ce déclenchement.

Pour les raisons ci-dessus, il est donc intéressant de monitorer, en temps réel, le régime réel du transformateur et les événements survenant dans son exploitation. On connaît à cet effet des documents ES2253979, US4654806 et WO2014135015 des transformateurs électriques instrumentés pour pouvoir en surveiller le fonctionnement. Dans ces approches connues, la cuve du transformateur et les autres éléments qui le composent sont munis de capteurs distribués visant à déterminer ses paramètres principaux de fonctionnement : température, pression et niveau du fluide, charge électrique du secondaire ...

Dans certains cas, les mesures collectées sont utilisées à la fois pour monitorer le fonctionnement du transformateur et pour assurer les fonctions essentielles de sécurité. Cette approche nécessite de prévoir l'instrumentation préalable de la cuve et, plus généralement, du transformateur électrique. Il est difficile et coûteux de mettre en place une telle instrumentation sur le parc installé de transformateurs.

Le document FR 2 746 555 décrit un dispositif seulement de protection pour transformateur du type à diélectrique liquide, le dispositif comprenant au moins un contacteur électromécanique de sécurité dont le basculement est destiné à provoquer l'ouverture instantanée d'un disjoncteur du transformateur.

Enfin, on connaît également du document EP2682972 un dispositif de monitorage de relais de protection de transformateur qui comprend un dispositif de détection d'état ouvert ou fermé d'interrupteur. Le circuit de détection peut fonctionner (c'est-à-dire détecter l'état ouvert ou fermé de l'interrupteur) même en l'absence d'une tension Vₑₓₜ, en cherchant à établir une tension sur l'une des bornes de l'interrupteur lorsque cette tension extérieure est nulle. Le circuit de détection est branché en permanence, en parallèle, et en liaison galvanique avec le contact de sécurité. En cas de défaillance de tout ou partie du circuit de détection, il peut y avoir mise en court-circuit de celui-ci et donc du contact de sécurité. Cette défaillance peut entrainer la mise hors tension du transformateur et l'impossibilité de le réenclencher si le court-circuit persiste.

### OBJET DE L'INVENTION

Un but de l'invention est donc de proposer un dispositif permettant de réaliser un monitorage des transformateurs de distribution facile à mettre en œuvre, sans ajouter d'instrumentation supplémentaire, ni bouleverser les habitudes des installateurs et dont la défaillance est peu susceptible d'entrainer la mise hors tension du transformateur.

### BREVE DESCRIPTION DE L'INVENTION

En vue de la réalisation de ce but, l'objet de l'invention propose un dispositif de protection et de monitorage pour transformateur électrique du type à diélectrique liquide enfermé dans une cuve hermétique selon la revendication 10.

On peut de la sorte monitorer au moins les évènements de basculement du ou des contacteur(s) électromécanique(s) de sécurité sans modifier la fonction de protection du transformateur assuré par ce ou ces contacteur(s) et sans interférer avec ces contacteurs.

Selon d'autres caractéristiques avantageuses et non limitatives de l'invention, prises seules ou selon toute combinaison techniquement réalisable :
- le contacteur électromécanique est compris dans un détecteur électromécanique à seuil de température, de pression ou de niveau du diélectrique liquide ;
- le circuit de détection comprend des composants pour conditionner un signal brut de détection ;
- l'unité électronique de mesure comprend un moyen de stockage d'énergie ;
- l'unité électronique de mesure comprend une interface de communication ;
- le dispositif comprend au moins un circuit de mesure d'une information de monitorage du transformateur, le circuit de mesure étant électriquement relié à l'unité électronique de mesure ;
- le circuit de mesure est un circuit de mesure du niveau, de la température ou de la pression du diélectrique liquide, un circuit de mesure du champ magnétique émis par des enroulements du transformateur ou un circuit de mesure de vibrations ;
- le dispositif comprend un premier espace interne en communication fluidique avec le diélectrique liquide de la cuve et un deuxième espace interne, distinct du premier espace interne, dans lequel le contacteur électromécanique de sécurité et une partie au moins du circuit de détection sont disposés ;
- l'unité électronique de mesure est disposée dans un troisième espace interne du dispositif, distinct du premier espace interne et du deuxième espace interne.

Enfin, selon un autre aspect encore, l'objet de l'invention propose un procédé de protection et de monitorage d'un transformateur du type à diélectrique liquide enfermé dans une cuve hermétique selon la revendication 10.

Selon d'autres caractéristiques avantageuses et non limitatives de cet aspect de l'invention, prises seules ou selon toute combinaison techniquement réalisable :
- le procédé comprend la mesure répétitive et l'enregistrement dans l'unité électronique de mesures d'au moins une caractéristique du diélectrique liquide ou des enroulements du transformateur ;
- le procédé comprend une étape de traitement de l'événement de basculement et des mesures pour établir et tracer un événement significatif ;
- l'étape de traitement comprend l'effacement, dans l'unité électronique de mesure, des données qui ne sont pas situées dans un voisinage temporel de l'événement significatif.

### BREVE DESCRIPTION DES FIGURES

D'autres caractéristiques et avantages de l'invention ressortiront de la description détaillée de l'invention qui va suivre en référence aux figures annexées sur lesquels :

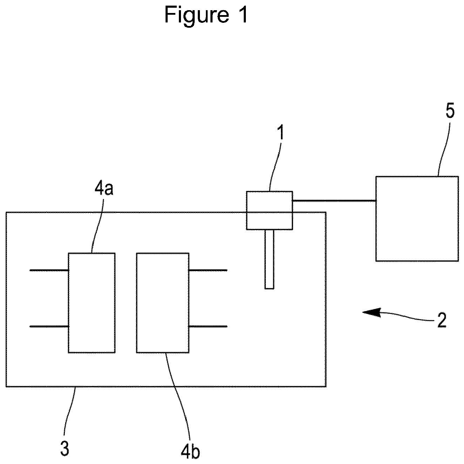

[Fig. 1] La figure 1 représente un transformateur électrique équipé d'un dispositif de protection et de monitorage conforme à la présente invention ;
[Fig. 2a]
[Fig. 2b]
[Fig. 2c] Les figures 2a à 2c représentent une architecture du dispositif de protection et de monitorage conforme à l'invention ;
[Fig. 3] La figure 3 représente un dispositif de protection et de monitorage muni d'un détecteur à seuil de température, de pression et de niveau ;
[Fig. 4a]
[Fig. 4b]

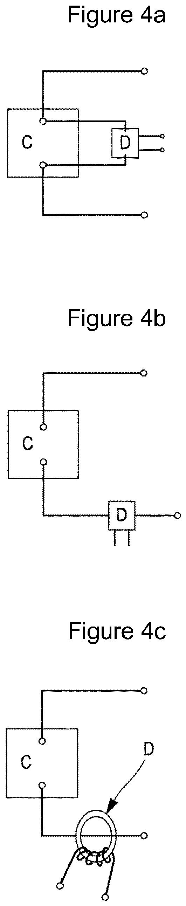

[Fig. 4c] Les figures 4a à 4c représentent trois configurations possibles d'un circuit de détection ;

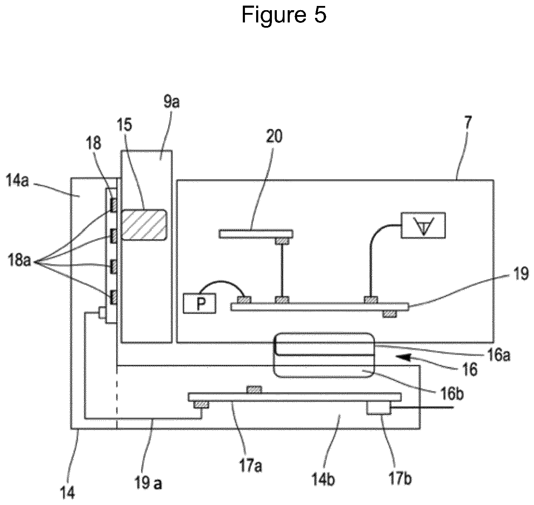

[Fig. 5] La figure 5 représente une architecture du dispositif mettant en œuvre des fonctions avancées de monitorage.

### DESCRIPTION DETAILLEE DE L'INVENTION

La figure 1 représente une vue d'ensemble, schématique, d'un transformateur électrique 2 équipé d'un dispositif de protection et de monitorage 1 conforme à la présente description. Le transformateur 2 comprend une cuve hermétique 3 retenant un liquide ou un fluide diélectrique dans lequel sont plongés des enroulements primaire 4a et secondaire bobinés sur un circuit magnétique 4b assurant la transformation électrique.

La cuve 3 est muni d'une ouverture supérieure dont la périphérie peut recevoir le dispositif de protection et de monitorage 1 afin de l'immerger en partie dans le liquide diélectrique, comme cela sera décrit en détail dans la suite de cet exposé. L'ouverture supérieure de la cuve 3 est généralement prévue pour permettre le remplissage et la remise à niveau de la cuve en liquide diélectrique. Le dispositif 1 est configuré pour occuper l'emplacement inutilisé d'une pièce de fermeture étanche de cette ouverture, tel qu'un bouchon.

Le transformateur 2 comprend également une armoire de commande électrique 5, contenant notamment les moyens permettant d'isoler électriquement les enroulements primaire et/ou secondaire 4a, 4b du réseau électrique lorsqu'un événement de sécurité est détecté par le dispositif 1. L'armoire 5 peut ainsi comprendre un disjoncteur comprenant une bobine de détection reliée à une borne de connexion du dispositif 1, sur laquelle est reporté un signal électrique dont le basculement indique la survenance d'un événement de sécurité.

### Description générale du dispositif de protection et de monitorage

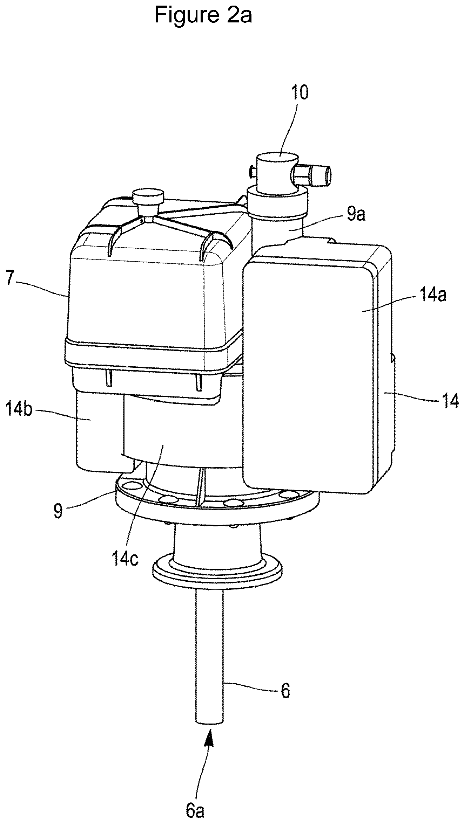

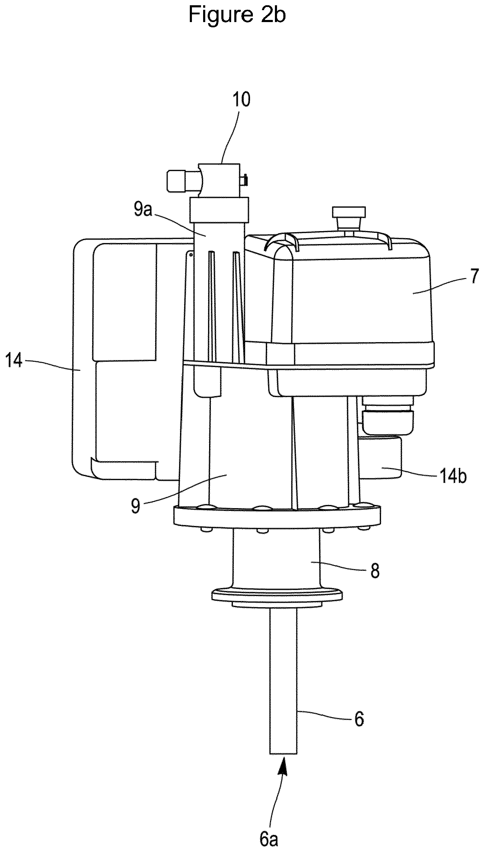

En référence aux figures 2a à 2c, on décrit maintenant le dispositif de protection et de monitorage 1 qui reprend les principes structurels du dispositif de sécurité décrit dans le document FR2737357.

Le dispositif 1 comprend un tube plongeur 6 dont l'extrémité distale 6a est fermée. Lorsque le dispositif 1 est disposé de manière conforme sur la cuve 3 du transformateur, l'extrémité distale 6a du tube plongeur 6 est immergée dans le liquide diélectrique. Le tube plongeur 6 dispose également d'une extrémité proximale 6b ouverte et débouchante dans un boîtier supérieur 7 auquel le tube 6 est relié de manière étanche par l'intermédiaire d'une semelle 6d. Le boîtier supérieur 7 est destiné à recevoir les dispositifs électromécaniques de sécurité ainsi que le câblage permettant de les relier aux bornes de connexion du dispositif 1. L'ensemble des bornes du dispositif 1 forment collectivement un bornier qui peut être disposé dans le boîtier supérieur 7.

Le dispositif 1 représenté sur les figures 2a à 2c comprend également une embase 8 destinée à fixer le dispositif 1 sur le contour de l'ouverture de la cuve 3. L'embase 8 est ici cylindrique et est traversée par le tube plongeur 6. Une partie intermédiaire 9, également traversée par le tube plongeur 6, est fixée à l'embase 8 de manière étanche. La partie intermédiaire 9 supporte le boîtier supérieur 7. Le boîtier supérieur 7 et la partie intermédiaire 9 sont toutefois isolés de manière étanche l'un de l'autre. Dans l'exemple représenté, le boîtier supérieur 7 est composé d'un couvercle et d'une partie inférieure, la partie inférieure formant avec la partie intermédiaire 9 un ensemble monobloc.

La partie intermédiaire 9 comprend un tube de remplissage 9a obturé par un bouchon 10 amovible, ici équipé d'un purgeur. Le fluide diélectrique déversé dans le tube de remplissage 9a peut circuler dans l'espace interne de la partie intermédiaire 9 et à travers l'espace interne de l'embase 8 pour venir remplir la cuve 3 du transformateur électrique 2.

Dans un état de fonctionnement normal du transformateur et du dispositif 1, le fluide diélectrique emplit entièrement la cuve 3, l'espace interne de l'embase 8 et une partie au moins de la partie intermédiaire 9. Avantageusement, cette partie est réalisée en un matériau transparent, par exemple en plastique, afin de permettre l'inspection visuelle du niveau de fluide. Comme cela sera décrit dans le détail ultérieurement, la partie intermédiaire 9 peut comprendre un flotteur principal 13a pour déclencher la disjonction du transformateur électrique 2 lorsqu'il franchit à la baisse un seuil de niveau critique. On peut également prévoir un flotteur secondaire 15 disposé dans le tube de remplissage et permettant d'observer de faibles variations du niveau du fluide diélectrique (le tube présentant effectivement une section plus réduite que la partie intermédiaire). Il est nécessaire dans ce cas que le niveau de ce fluide, dans un état normal de fonctionnement du transformateur 2, soit positionné dans le tube de remplissage 9a dans une zone supérieure de ce tube.

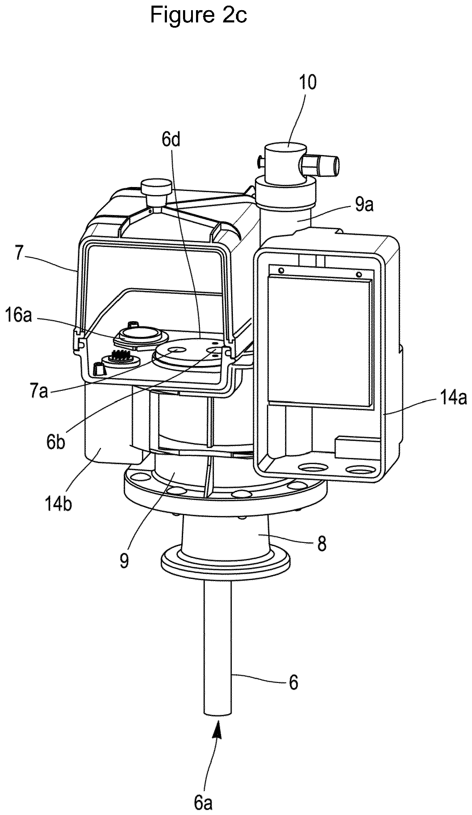

Le dispositif 1 représenté sur les figures 2a à 2c comprend également un boîtier périphérique 14 qui est destiné à recevoir des composants électroniques actifs tel que cela sera présenté ultérieurement. Le boîtier périphérique 14 comprend une première portion 14a disposée le long et contre le tube de remplissage 9a et une seconde portion 14b agencée en partie sous le boîtier supérieur 7. Les deux portions 14a, 14b sont reliées entre elles par une portion intermédiaire 14c enserrant un flanc de la partie intermédiaire 9. Pour relier électriquement les composants disposés dans le boîtier périphérique 14 à ceux disposés dans le boîtier supérieur 7, les deux boîtiers peuvent respectivement porter des parties complémentaires 16a (visible sur la figure 2c), 16b d'un connecteur 16 qui peuvent s'emboîter l'une à l'autre.

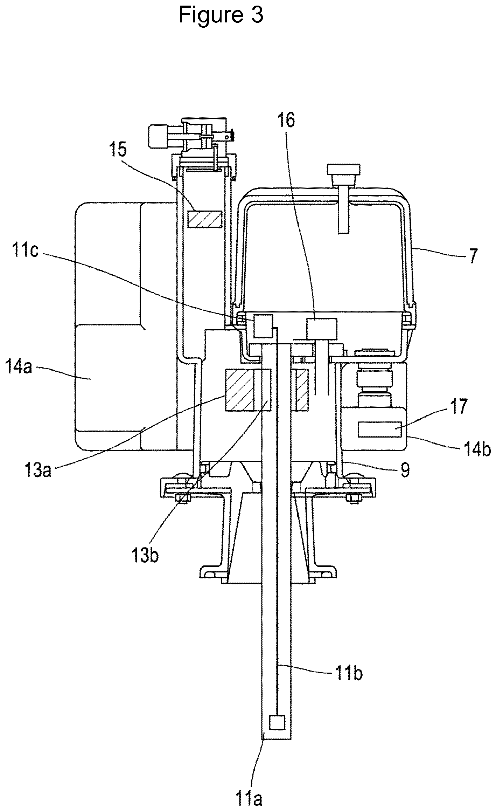

D'une manière générale, le dispositif 1 est composé d'un premier espace interne défini par la partie intermédiaire 9 et l'embase 8 en communication fluidique avec la cuve 3. Le dispositif 1 est également composé d'un deuxième espace interne défini par le volume interne du tube plongeur 6 et par le boîtier supérieur 7. Ce deuxième espace interne n'est pas en communication fluidique avec l'intérieur de la cuve 3 ou avec le premier espace interne. Il a vocation à recevoir les éléments passifs ou actifs, électromécaniques ou électroniques, comme cela sera présenté dans une partie ultérieure de cette description. Le dispositif est également composé d'un troisième espace interne défini par le boîtier périphérique 14 destiné à recevoir l'électronique active du dispositif 1, tel qu'une unité électronique de mesure 17 visible sur la figure 3, électriquement relié aux éléments du deuxième espace interne. Les trois espaces internes sont distincts les uns des autres, c'est-à-dire séparés les uns des autres par des parois et de manière étanche, pour former un dispositif 1 modulaire. Ce caractère modulaire du dispositif de protection et de monitorage 1 forme un aspect très avantageux de l'invention qui assure la sécurité de l'ensemble, sa fiabilité, la facilité de son montage et de sa maintenance.

### Fonctions de protection

Pour assurer ses fonctions de protection du transformateur 2, le dispositif comprend au moins un contacteur électromécanique à seuil de sécurité, dont le basculement est destiné à provoquer l'ouverture instantanée du disjoncteur du transformateur 2. Il peut par exemple s'agir de détecter un niveau insuffisant de diélectrique dans la cuve 3, une température ou une pression excessive de ce diélectrique.

Par "contacteur électromécanique", on désigne un dispositif de commutation réalisant un contact électrique sec entre deux de ses bornes. Le dispositif peut commuter entre une position ouverte ou fermée lorsqu'une grandeur mesurée par un transducteur (par exemple de pression, de température, de niveau) franchit un seuil prédéterminé. Il peut aussi s'agir d'un contacteur à ouverture (qui commute en position ouverte lors du franchissement du seuil), à fermeture (qui commute en position fermée lors du franchissement du seuil) ou même d'un contacteur inverseur pouvant être configuré selon l'un ou l'autre de ces modes de fonctionnement. Le transducteur et le contacteur forment, en combinaison, un détecteur électromécanique à seuil.

Quel que soit le type de contacteur choisi, celui-ci présente au moins deux bornes de commutation électriquement reliées à un bornier du dispositif de protection et de monitorage 1. Une tension alternative ou continue (typiquement comprise entre 24V et 240V) est appliquée aux bornes de commutation du contacteur, par exemple à partir d'une source disposée dans l'armoire 5 électriquement reliée aux bornes du dispositif 1. La présence ou l'absence de tension dans ce circuit peut être détectée par la bobine de détection du disjoncteur du transformateur 2.

Dans l'exemple représenté sur la figure 3, le dispositif 1 est ainsi muni d'un détecteur électromécanique à seuil de température, de pression et de niveau comprenant chacun un contacteur électromécanique 11c, 12c, 13b dont le basculement est provoqué par le franchissement d'un seuil prédéterminé en température, en pression ou en niveau du fluide diélectrique de la cuve 3.

Le détecteur de température est formé d'un bulbe 11a, c'est-à-dire d'une cavité remplie d'un matériau se dilatant selon la température à laquelle il est soumis, et d'un capillaire 11b permettant de transmettre l'effort produit par la dilatation du matériau du bulbe 11a. Celui-ci est disposé dans le tube plongeur 6 au niveau de son extrémité distale 6a afin d'être exposé à la température du liquide diélectrique. Le capillaire 11b court à l'intérieur du tube 6 pour déboucher dans le boîtier supérieur 7 où il est relié à un premier contacteur électromécanique 11c configuré pour basculer lorsque la température à laquelle est exposé le bulbe 11a franchit à la hausse un seuil prédéterminé. On peut prévoir de munir le dispositif 1 de plusieurs détecteurs, calibrés pour basculer lors du franchissement de deux seuils distincts de température.

Le détecteur de pression peut prendre la forme d'un pressostat disposé dans le boîtier supérieur 7. Un tube de raccordement du pressostat est engagé dans une ouverture 7a du boîtier supérieur 7 débouchant dans la partie intermédiaire 9. Le tube de raccordement plonge dans le liquide diélectrique emplissant l'espace interne de la partie intermédiaire 9 afin d'en capter la pression. Celle-ci est transmise à une membrane du pressostat dont la déformation provoque le basculement d'un deuxième contacteur lorsque celle-ci franchit à la hausse un seuil prédéterminé.

Le détecteur de niveau peut comprendre le flotteur principal 13a logé dans la partie intermédiaire 9, ici monté à coulissement autour du tube plongeur 6. Le flotteur 13a est porté par le diélectrique liquide emplissant au moins en partie l'espace interne de la partie intermédiaire 9. Lorsque le niveau du liquide diélectrique est conforme, le flotteur principal 13a est plaqué contre ou proche de la paroi supérieure de la partie intermédiaire 9. Le flotteur principal 13a porte au moins un aimant. Le détecteur de niveau comprend également un troisième contacteur électromécanique 13b sensible au champ magnétique produit par l'aimant pour provoquer son basculement. Ce contacteur 13b est disposé dans le tube plongeur 6 au niveau de la partie intermédiaire 9 de sorte que le franchissement à la baisse d'un seuil de niveau du liquide diélectrique provoque son basculement.

Les détecteurs qui viennent d'être décrits forment des exemples particuliers de mise en œuvre de détecteurs intégrés au dispositif 1. On pourra bien entendu munir ce dispositif 1 d'autres types de détecteurs ou réaliser les fonctions de détection décrites sous d'autres formes de mise en œuvre, sans sortir du cadre de la présente invention. Dans tous les cas toutefois, le dispositif 1 est muni d'au moins un contacteur électromécanique assurant une fonction de détection d'un paramètre de sécurité du transformateur 2. Comme on l'a déjà évoqué, chaque contacteur est électriquement relié par l'intermédiaire de fils électriques circulant dans le boîtier supérieur 7 à des bornes d'un bornier, afin de relier le dispositif 1 aux autres éléments du transformateur 2 et notamment au disjoncteur de l'armoire électrique 5.

### Fonctions de monitorage

Pour assurer ses fonctions de monitorage, le dispositif de protection et de monitorage 1 comprend également un (ou des) circuit(s) de détection du basculement du (ou des) contacteur(s). On note en préambule que les pièces assurant le contact sec des contacteurs ou les pièces qui déclenchent le basculement de ces contacteurs ne sont pas directement accessibles, car ils sont enfermés dans le pressostat, le thermostat, dans le tube plongeur 6 ou, d'une manière plus générale, enfouies dans le détecteur dont elles font partie. Plusieurs approches sont toutefois possibles pour néanmoins réaliser la détection de basculement.

Selon une première approche représentée sur la figure 4a, le circuit de détection D comprend un dispositif de mesure de la tension ou de l'absence de tension disponible aux bornes du contacteur C. Pour permettre cela, on prévoit un câblage supplémentaire en parallèle de celui reliant les bornes de commutation du contacteur C aux bornes du dispositif 1. Cette approche est avantageuse en ce qu'elle permet de s'assurer du raccordement effectif du contacteur au reste de l'installation lorsque l'on détecte la présence d'une tension. Toutefois, la défaillance du circuit de détection D, un court-circuit par exemple, peut compromettre le bon fonctionnement du contacteur et provoquer le déclenchement intempestif du disjoncteur.

Selon une deuxième approche représentée sur la figure 4b, le circuit de détection D comprend un dispositif « shunt » dans le câblage électrique reliant le contacteur C aux bornes du dispositif 1. Lorsque le contacteur bascule, un courant circule dans ce dispositif rendant possible sa détection. Toutefois, l'insertion du circuit de détection D dans le circuit électrique comprenant le contacteur pose les mêmes problèmes de sécurité que ceux évoqués dans la première approche, notamment en rendant inactif le circuit de sécurité en cas de rupture du shunt.

Aussi, et selon une troisième approche qui est celle retenue par la présente invention et représentée sur la figure 4c, on préférera procéder à la détection du basculement du contacteur C par mesure indirecte du courant. Dans cette approche préférée, le circuit de détection D peut prendre la forme d'un transformateur de courant. Ce transformateur de courant peut comprendre un primaire constitué d'une ou plusieurs spires enroulées autour du fil de câblage du contacteur C. Il exploite le champ magnétique produit lorsque le contacteur C est traversé par le courant d'appel, lors du basculement des contacts. Pour favoriser l'amplitude de ce courant d'appel et faciliter sa détection, on choisira de relier le contacteur C à une charge de nature inductive comme c'est le cas de la bobine de déclenchement du disjoncteur, plutôt qu'à une charge de nature résistive.

Pratiquement, le circuit de détection D peut mettre en œuvre un transformateur de courant sur tore de ferrite plein, comme cela est représenté sur la figure 4c, le tore de ferrite étant disposé autour d'un conducteur reliant le contacteur à une borne du dispositif 1. Alternativement, le transformateur de courant peut mettre en œuvre un tore de ferrite coupé ou un capteur à effet Hall introduit dans l'entrefer d'un tore, ou encore une bobine de Rogoswski, ou toute autre forme de transformateur de courant.

Quelle que soit l'approche choisie, le circuit de détection fournit un signal brut de détection sur lequel il est possible d'identifier la survenance d'un événement de basculement du contacteur. Le circuit de détection peut également réaliser, au moins en partie, le conditionnement du signal brut pour faciliter la détection de l'événement et/ou son traitement numérique. Cela est tout particulièrement vrai lorsque le circuit de détection met en œuvre une mesure indirecte du courant. Dans un tel cas en effet, le basculement du contacteur provoque un signal brut transitoire dont l'amplitude de plusieurs volts peut-être facilement reconnaissable, mais présente une durée très courte (le temps de montée peut-être aussi petit que 25 ns) et qui nécessite donc un échantillonnage à extrêmement haute fréquence qu'il serait plus souhaitable d'éviter.

À titre d'exemple, le traitement de conditionnement peut correspondre à un écrêtage et à un seuillage du signal brut de manière à identifier des pics principaux de ce signal. Ces pics peuvent être mémorisés, par un circuit de type bascule, et ce signal mémorisé échantillonné à fréquence réduite par l'intermédiaire d'un circuit "tout ou rien", par exemple une entrée tout ou rien de l'unité électronique de mesure. Parallèlement à ce premier traitement, et de manière optionnelle, on peut numériser à très grande cadence le signal brut ou le signal brut écrêté et seuillé, par exemple toutes les 20ns, et conserver dans un circuit de mémoire temporaire (par exemple du type FPGA) un nombre limité d'échantillons, pour conserver une fenêtre d'une durée de quelques 10ms de signal brut. L'unité électronique de mesure 17 peut mettre en œuvre un traitement visant, lors de la réception d'une valeur positive de détection dans le signal échantillonné en tout ou rien, à vérifier dans les échantillons du circuit de mémoire temporaire avec plus de précision la survenance effective d'un événement de basculement. On évite ainsi les fausses détections qui pourraient se produire à partir de l'analyse simple du signal tout ou rien en discriminant plus finement le signal brut.

Dans une forme alternative du traitement de conditionnement qui peut être intégré au circuit de détection, on peut prévoir de conditionner le signal brut par un circuit résonnant accordé (du type RLC) pour provoquer des oscillations libres sur une période de temps étendue lors de la survenance d'un transitoire correspondant à un basculement. Le signal en sortie du circuit résonnant peut être filtré pour en récupérer l'enveloppe. On peut alors échantillonner à une fréquence raisonnable, par exemple à l'aide d'une entrée dédiée de l'unité électronique de mesure 17, l'enveloppe du signal. Cette fréquence raisonnable peut-être de l'ordre de 1kHz afin de pouvoir détecter efficacement un basculement effectif d'un contact.

Que le signal brut de mesure ait été conditionné ou non, le dispositif de protection et de monitorage 1 comprend dans tous les cas une unité électronique de mesure 17. Cette unité 17 est reliée au circuit de détection par l'intermédiaire d'une entrée tout ou rien ou d'un convertisseur analogique-digital comme on vient de le décrire, pour recevoir le signal fourni par le circuit de détection et repérer la survenance d'un événement de basculement. Cet événement est tracé, c'est-à-dire horodaté et mémorisé par l'unité électronique de mesure 17 afin de pouvoir être analysé ultérieurement.

L'unité électronique de mesure 17 est typiquement mise en œuvre par un microcontrôleur ou une carte à microcontrôleur. Cette unité est alimentée électriquement à partir d'une source électrique, par exemple une source logée dans l'armoire électrique 5. Pour parer à une interruption de fourniture d'énergie, par exemple en conséquence d'une défaillance du transformateur qui conduit à le faire disjoncter, l'unité électronique de mesure 17 est équipée d'un moyen de stockage d'énergie, tel qu'une batterie ou d'une capacité de très grande valeur. L'unité 17 comprend également des moyens de stockage des événements de basculement et des autres données prélevées par le dispositif 1. Ces moyens peuvent être constitués par de la mémoire non volatile intégrée au microcontrôleur ou être une mémoire non volatile additionnelle disposée sur la carte à microcontrôleur. Il peut s'agir d'une mémoire amovible, permettant alors à un opérateur de collecter simplement l'ensemble des données enregistrées. Mais, avantageusement, l'unité électronique de mesure 17 comprend une interface de communication permettant d'envoyer les données enregistrées à un dispositif de commande extérieur. Outre l'échange de données, l'interface de communication peut permettre au dispositif de commande extérieur de diagnostiquer, configurer ou plus généralement intervenir sur l'unité électronique de mesure. L'interface de communication peut notamment relier l'unité électronique de mesure 17 à un dispositif de commande extérieur placée dans l'armoire électrique 5 ou à un connecteur d'un tel dispositif. La liaison entre l'interface de communication et le dispositif de commande extérieur peut-être de toute nature, filaire ou non filaire, et employer tout protocole qui convient. On pourra également prévoir plusieurs canaux de communication permettant à distance de piloter, relever les mesures et les événements enregistrés ou recevoir des alarmes émises par le dispositif de protection et de monitorage 1, par exemple à partir d'une centrale de commande gérant toute une flotte de transformateurs, et de manière concourante, de piloter ou de relever ce dispositif 1 à partir d'un dispositif de commande intégré à l'armoire électrique 5 ou relié temporairement à cette armoire par un opérateur de maintenance.

Ainsi, un dispositif conforme à l'invention peut être utilisé pour la protection et le monitorage d'un transformateur du type à diélectrique liquide enfermé dans une cuve hermétique. Au cours de cette utilisation, on détecte, par le circuit de détection, un évènement de basculement d'un contacteur électromécanique de sécurité et on le trace par l'unité électronique de mesure, l'événement de basculement.

### Circuit de mesure

Le dispositif 1 peut naturellement être équipé d'autres circuits ou composants afin de collecter par l'intermédiaire de l'unité électronique de mesure 17 un ensemble plus riche d'informations de monitorage. On peut chercher ainsi à munir le dispositif d'un circuit de mesure d'au moins une caractéristique du diélectrique liquide ou d'une grandeur caractéristique liée au régime de fonctionnement du transformateur, en vue de les enregistrer dans l'unité électronique de mesure. Il peut s'agir de mesurer répétitivement et collecter les données de monitorage à l'aide d'un circuit de mesure du niveau de fluide, d'un circuit de mesure de sa température et de sa pression, d'un circuit de mesure du champ magnétique émis par les enroulements du transformateur ou d'un circuit de mesure de vibrations. On peut de la sorte, en exploitant les données collectées, surveiller le bon fonctionnement du transformateur 2, sa charge, voire même estimer sa durée de vie, planifier les interventions de maintenance préventives. Tous ces circuits de mesures sont disposés dans le dispositif 1, électriquement reliés à l'unité électronique de mesure 17. Il n'est donc pas nécessaire d'équiper en capteurs les autres éléments du transformateur 2 et notamment sa cuve 3. La faculté de pouvoir relever des données de monitorage du régime de fonctionnement du transformateur, sans équiper directement ces enroulements, forme un aspect très avantageux de d'un dispositif de protection et/ou de monitorage conforme à un aspect de l'invention, comme cela sera illustré dans un passage suivant de cette description.

Dans son usage, un dispositif 1 conforme à l'invention permet donc de mesurer répétitivement et d'enregistrer dans l'unité électronique de mesure 17 au moins une caractéristique du diélectrique liquide et/ou une grandeur caractéristique du régime de fonctionnement du transformateur 2.

La configuration modulaire du dispositif 1 permet de disposer dans le deuxième espace interne formé du boîtier supérieur 7 et du volume interne du tube plongeur 6 tous les composants passifs ou actifs ; de protection ou de monitorage, tels que les détecteurs électromécaniques à seuil et une partie au moins des circuits de détection. On pourra similairement placer l'unité électronique de mesure 17 et les autres éléments non passifs dans le troisième espace interne formé par le boîtier périphérique 14.

À titre d'exemple, on a représenté sur la figure 5 une architecture mettant en œuvre des fonctions avancées de monitorage. On a représenté schématiquement sur cette figure le boîtier supérieur 7, le tube de remplissage 9a de la partie intermédiaire 9 muni du flotteur secondaire 15, et la partie périphérique 14 comprenant les deux portions 14a, 14b présentées sur la figure d'ensemble 2a.

Sur l'exemple de la figure 5, l'unité électronique de mesure 17 est formée d'une carte à microcontrôleur 17a disposée dans la seconde portion 14b de la partie périphérique 14. Cette carte 17a est reliée électriquement au connecteur 16 par l'intermédiaire d'une partie 16b ici enfichée dans la partie complémentaire 16a solidaire du boîtier supérieur 7. Le connecteur 16 permet donc de relier électriquement les composants disposés dans le boîtier supérieur 7 à l'unité électronique de mesure 17 et aux éventuels autres composants disposés dans le boîtier supérieur 7. La carte à microcontrôleur 17a porte un boîtier d'alimentation et de raccordement 17b permettant de relier l'unité électronique de mesure 17 à une source externe d'énergie et au dispositif externe de commande. À cet effet, le boîtier d'alimentation et de raccordement 17b est associé à des câbles d'alimentation et de communication 17c qui peuvent être reliés à l'armoire électrique 5. La carte à microcontrôleur 17a peut également comprendre les moyens de stockage d'énergie, la mémoire non volatile, et tout autre composant contribuant à former, en combinaison, l'unité de mesure 17. Cette carte 17a peut également comporter les composants de conditionnement du signal brut fourni dans le circuit de détection ou une partie de ceux-ci.

Dans l'exemple de la figure 5, l'unité électronique de mesure 17 est reliée à un ensemble de circuits de mesure permettant de monitorer le fonctionnement du transformateur 2. Ainsi, on a placé dans la première portion 14a du boîtier périphérique qui est agencé le long du tube de remplissage, une platine électronique 18. Cette platine porte une pluralité de capteurs magnétiques 18a, par exemple des capteurs à effet Hall à sortie analogique, disposés à espacements réguliers le long du tube de remplissage 9a. Le flotteur secondaire 15 est équipé d'au moins un aimant permanent générant un champ magnétique radial, mesuré avec une intensité variable par les capteurs magnétiques 18a selon la position relative du flotteur secondaire 15 vis-à-vis de ces capteurs 18a. Les signaux fournis par les capteurs 18a sont reportés, par exemple par l'intermédiaire d'une nappe de connexion électrique 19a, à la carte à microcontrôleur 17a pour qu'ils soient traités par l'unité électronique de mesure 17.

L'unité électronique de mesure 17 est ainsi configurée pour traiter numériquement les signaux fournis par les capteurs magnétiques 18a et établir une mesure du niveau de fluide diélectrique. Cette mesure peut être tracée, c'est-à-dire horodatée et mémorisée dans la mémoire de l'unité électronique de mesure 17. La mesure du niveau du fluide électrique permet une détection précoce d'une variation significative de ce niveau et permet d'anticiper de manière préventive le basculement du contact de sécurité associé à ce niveau. On peut alors prévenir l'actionnement du disjoncteur. La mesure du niveau d'huile peut être prélevée toutes les 30 secondes environ, ou pour le moins toutes les minutes. Il peut également être prélevé plus fréquemment, par exemple une ou deux fois par seconde.

Poursuivant la description de l'exemple représenté sur la figure 5, le boîtier supérieur 7 comprend également un circuit de mesure de la pression et de la température du liquide diélectrique. Ce circuit comprend un capteur disposé dans le boîtier supérieur 7, sur la semelle 6d du tube plongeur 6. À cet effet, la paroi inférieure du boîtier 7 et la semelle 6d sont munies d'une seconde ouverture débouchant dans la partie intermédiaire 9, permettant d'exposer la tête de mesure du capteur au fluide diélectrique. Les grandeurs analogiques de pression et de température du fluide relevées par le capteur sont reportées sur une carte de routage 19 à laquelle sont électriquement reliés tous les circuits disposés dans le boîtier supérieur 7 et dans le tube 6. La carte de routage 19 assure le routage des signaux et leur connexion au connecteur 16 pour qu'ils soient transmis à l'unité électronique de mesure 17.

Un port d'acquisition de l'unité électronique de mesure 17 échantillonne à une fréquence de l'ordre de 1 kHz le signal de pression fourni par le capteur afin de pouvoir identifier une montée brusque de la pression qui, sans déclencher toutefois le contacteur du pressostat, fournit des informations importantes pouvant affecter la durée de vie du transformateur et sa performance. Le signal de température du fluide électrique fourni par le capteur peut quant à lui être relevé à une fréquence moindre, par exemple une fois par minute ou jusqu'à une fois toutes les 5 minutes.

Très avantageusement, on peut également munir le dispositif 1 de capteurs du champ magnétique et/ou des vibrations générés par les enroulements ou d'autres parties actives du transformateur 2 qui sont des grandeurs indicatrices du régime de fonctionnement du transformateur 2. Les mesures correspondantes peuvent être établies par un unique capteur fournissant ces données selon trois axes ou par une pluralité de capteurs. Elles peuvent être fournies à l'unité de mesure 17 directement (si les capteurs sont disposés dans la partie périphérique) où via la carte de routage 19 et le connecteur 16 (s'ils sont positionnés dans le boîtier supérieur 7). La faculté de fournir les informations relatives au fonctionnement des enroulements est un avantage important de l'invention, dans sa fonction de monitorage.

D'une manière générale, l'unité électronique de mesure 17 peut comporter toute autre sorte de capteur et prélever les données à la fréquence qui convient, selon la dynamique des phénomènes mesurés, et de l'ordre de 10 Hertz pour la mesure de champs et d'accélération/vibration.

Pour finir la description de la figure 5, on a également représenté une carte additionnelle 20 pour porter le ou les circuits de détection.

Ainsi équipé, il est bien apparent que le dispositif de protection et de monitorage 1 forme une solution complète et compacte pour la protection et le suivi du transformateur 2.

Bien entendu l'invention n'est pas limitée aux modes de mise en œuvre décrits et on peut y apporter des variantes de réalisation sans sortir du cadre de l'invention tel que défini par les revendications.

Ainsi, l'unité électronique de mesure 17 peut implémenter d'autres fonctions que celles qui viennent d'être décrites dans le détail. Elle pourra notamment traiter les données ou mesures acquises pour détecter le franchissement de seuil, des variations soudaines, le déclenchement des contacts pour établir et tracer des événements significatifs. Ces événements peuvent provoquer l'émission des messages d'alarme, par exemple via l'interface de communication ou via une interface dédiée, à un dispositif externe de commande qui peut être disposé dans un central distant de supervision. L'unité peut également traiter les données pour limiter la quantité de mémoire nécessaire à leurs enregistrements. Il peut par exemple s'agir d'enregistrer des moyennes, des minima et maxima sur des fenêtres de temps prédéterminés plutôt que toutes les mesures relevées. À titre d'exemple complémentaire, il peut s'agir de ne mémoriser ou transmettre que les mesures situées au voisinage temporel (de quelques minutes ou de quelques heures avant ou après) des événements significatifs identifiés. En d'autres termes, les mesures n'étant pas situées dans le voisinage temporel d'un évènement significatif peuvent être effacées de la mémoire de l'unité électronique de mesure.

On pourra dans certains cas configurer un dispositif conforme à l'invention pour qu'il se limite à sa fonction de protection ou à sa fonction de monitorage.

Selon ce dernier aspect, on propose alors un dispositif de protection et/ou de monitorage pour transformateur du type à diélectrique liquide enfermé dans une cuve hermétique comprenant
- un circuit de mesure d'au moins une grandeur caractéristique du régime de fonctionnement du transformateur ;
- une unité électronique de mesure, reliée au circuit de mesure et configurée pour enregistrer une mesure fournie par le circuit de mesure.

Le circuit de mesure peut être un circuit de mesure du champ magnétique émis par les enroulements du transformateur ou un circuit de mesure de vibrations. Le dispositif peut comprendre au moins un contacteur électromécanique de sécurité dont le basculement est destiné à provoquer l'ouverture instantanée d'un disjoncteur du transformateur.

## Revendications

1. Dispositif de protection et de monitorage (1) pour transformateur (2) du type à diélectrique liquide enfermé dans une cuve hermétique (3), le dispositif (1) comprenant au moins un contacteur électromécanique de sécurité (11c, 12c, 13b) dont le basculement est destiné à provoquer l'ouverture instantanée d'un disjoncteur du transformateur (2), le dispositif (1) comprenant :
- un circuit de détection (D) du basculement du contacteur électromécanique (11c, 12c, 13b) ;
- une unité électronique de mesure (17), reliée au circuit de détection (D) et configurée pour tracer la survenance d'un événement de basculement ;
le dispositif étant **caractérisé en ce que** le circuit de détection comprend un transformateur de courant configuré pour mesurer le courant circulant dans le contacteur électromécanique par détection d'une variation de champ magnétique susceptible de survenir lors du basculement du contacteur électromécanique.

2. Dispositif (1) selon la revendication précédente dans lequel le contacteur électromécanique (11c, 12c, 13b) est compris dans un détecteur électromécanique à seuil de température, de pression ou de niveau du diélectrique liquide.

3. Dispositif (1) selon l'une des revendications précédentes dans lequel le circuit de détection (D) comprend des composants pour conditionner un signal brut de détection.

4. Dispositif (1) selon l'une des revendications précédentes dans lequel l'unité électronique de mesure (17) comprend un moyen de stockage d'énergie.

5. Dispositif (1) selon l'une des revendications précédentes dans lequel l'unité électronique de mesure (17) comprend une interface de communication.

6. Dispositif (1) selon l'une des revendications précédentes comprenant au moins un circuit de mesure d'une information de monitorage du transformateur, le circuit de mesure étant électriquement relié à l'unité électronique de mesure (17).

7. Dispositif (17) selon la revendication précédente dans lequel le circuit de mesure est un circuit de mesure du niveau (18, 18a), de la température ou de la pression du diélectrique liquide, un circuit de mesure du champ magnétique émis par des enroulements (4a, 4b) du transformateur (2) ou un circuit de mesure de vibrations.

8. Dispositif (1) selon l'une des revendications précédentes comprenant un premier espace interne (9,8) en communication fluidique avec le diélectrique liquide de la cuve (3) et un deuxième espace interne (6,7), distinct du premier espace interne (9,8), dans lequel le contacteur électromécanique (11c, 12c, 13b) de sécurité et une partie au moins du circuit de détection (D) sont disposés.

9. Dispositif (1) selon la revendication précédente, dans lequel l'unité électronique de mesure (17) est disposée dans un troisième espace interne (14) du dispositif (1), distinct du premier espace interne (9,8) et du deuxième espace interne (6,7).

10. Procédé de protection et de monitorage d'un transformateur (2) du type à diélectrique liquide enfermé dans une cuve (3) hermétique, le procédé comprenant :
- la détection par un circuit de détection (D) d'un évènement de basculement d'un contacteur électromécanique de sécurité (11c, 12c, 13b) destiné à provoquer l'ouverture instantanée d'un disjoncteur du transformateur (2), le circuit de détection (D) comprenant un transformateur de courant configuré pour mesurer le courant circulant dans le contacteur électromécanique par détection d'une variation de champ magnétique susceptible de survenir lors du basculement du contacteur électromécanique;
- le traçage, par une unité électronique de mesure (17), de l'événement de basculement.

11. Procédé selon la revendication précédente comprenant la mesure répétitive et l'enregistrement dans l'unité électronique de mesures (17) d'au moins une caractéristique du diélectrique liquide ou des enroulements (4a, 4b) du transformateur (2).

12. Procédé selon la revendication précédente comprenant une étape de traitement de l'événement de basculement et des mesures pour établir et tracer un événement significatif.

13. Procédé selon la revendication précédente dans lequel l'étape de traitement comprend l'effacement, dans l'unité électronique de mesure (17), des données qui ne sont pas situées dans un voisinage temporel de l'événement significatif.

## Patentansprüche

1. Schutz- und Überwachungsvorrichtung (1) für einen in einen hermetischen Tank (3) eingeschlossenen Transformator (2) der Art mit Isolierflüssigkeit, die Vorrichtung (1) umfassend mindestens einen elektromechanischen Sicherheitsschütz (11c, 12c, 13b), dessen Umschalten dafür bestimmt ist, das sofortige Öffnen eines Leistungsschalters des Transformators (2) zu bewirken, die Vorrichtung (1) umfassend:
- eine Erfassungsschaltung (D) des Umschaltens des elektromechanischen Schützes (11c, 12c, 13b);
- eine elektronische Messeinheit (17), die mit der Erfassungsschaltung (D) verbunden und zum Verfolgen des Auftretens eines Umschaltungsereignisses konfiguriert ist;
wobei die Vorrichtung **dadurch gekennzeichnet ist, dass** die Erfassungsschaltung einen Stromtransformator umfasst, der zum Messen des Stroms, der in dem elektromechanischen Schütz fließt, durch Erfassen einer Änderung des Magnetfelds konfiguriert ist, die wahrscheinlich auftritt, wenn der elektromechanische Schütz umgeschaltet wird.

2. Vorrichtung (1) nach dem vorstehenden Anspruch, wobei der elektromechanische Schütz (11c, 12c, 13b) in einem elektromechanischen Detektor für Temperatur-, Druck- oder Füllstandschwellenwert der Isolierflüssigkeit enthalten ist.

3. Vorrichtung (1) nach einem der vorstehenden Ansprüche, wobei die Erfassungsschaltung (D) Komponenten zum Konditionieren eines Erfassungsrohsignals umfasst.

4. Vorrichtung (1) nach einem der vorstehenden Ansprüche, wobei die elektronische Messeinheit (17) ein Energiespeichermittel umfasst.

5. Vorrichtung (1) nach einem der vorstehenden Ansprüche, wobei die elektronische Messeinheit (17) eine Kommunikationsschnittstelle umfasst.

6. Vorrichtung (1) nach einem der vorstehenden Ansprüche, umfassend mindestens eine Schaltung zum Messen von Transformatorüberwachungsinformationen, wobei die Messschaltung mit der elektronischen Messeinheit (17) elektrisch verbunden ist.

7. Vorrichtung (17) nach dem vorstehenden Anspruch, wobei die Messschaltung eine Schaltung zu Messen des Füllstands (18, 18a), der Temperatur oder des Drucks der Isolierflüssigkeit, eine Schaltung zum Messen des Magnetfelds, das durch die Wicklungen (4a, 4b) des Transformators (2) emittiert wird, oder eine Schaltung zum Messen von Schwingungen ist.

8. Vorrichtung (1) nach einem der vorstehenden Ansprüche, umfassend einen ersten Innenraum (9, 8) in Fluidverbindung mit der Isolierflüssigkeit des Tanks (3) und einen zweiten Innenraum (6, 7), der sich von dem ersten Innenraum (9,8) unterscheidet, in dem der elektromechanische Sicherheitsschütz (11c, 12c, 13b) und mindestens ein Teil der Erfassungsschaltung (D) angeordnet sind.

9. Vorrichtung (1) nach dem vorstehenden Anspruch, wobei die elektronische Messeinheit (17) in einem dritten Innenraum (14) der Vorrichtung (1) angeordnet ist, der sich von dem ersten Innenraum (9, 8) und von dem zweiten Innenraum (6, 7) unterscheidet.

10. Schutz- und Überwachungsverfahren eines in einem hermetischen Tank (3) eingeschlossenen Transformators (2) der Art mit Isolierflüssigkeit, das Verfahren umfassend:
- das Erfassen, durch eine Erfassungsschaltung (D), eines Umschaltungsereignisses eines elektromechanischen Sicherheitsschützes (11c, 12c, 13b), der dafür bestimmt ist, das sofortige Öffnen eines Leistungsschalters des Transformators (2) zu bewirken, die Erfassungsschaltung (D) umfassend einen Stromtransformator, der zum Messen des Stroms, der in dem elektromechanischen Schütz fließt, durch Erfassen einer Änderung des Magnetfelds konfiguriert ist, die wahrscheinlich auftritt, wenn der elektromechanische Schütz umgeschaltet wird;
- Verfolgen, durch eine elektronische Messeinheit (17), des Umschaltungsereignisses.

11. Verfahren nach dem vorstehenden Anspruch, umfassend das wiederholte Messen und das Aufzeichnen in der elektronischen Messeinheit (17) mindestens einer Eigenschaft der Isolierflüssigkeit oder der Wicklungen (4a, 4b) des Transformators (2).

12. Verfahren nach dem vorstehenden Anspruch, umfassend einen Schritt des Verarbeitens des Umschaltungsereignisses und von Messungen zum Feststellen und Verfolgen eines signifikanten Ereignisses.

13. Verfahren nach dem vorstehenden Anspruch, wobei der Verarbeitungsschritt das Löschen, in der elektronischen Messeinheit (17), der Daten umfasst, die nicht in zeitlicher Nähe des signifikanten Ereignisses liegen.

## Claims

1. Protection and monitoring device (1) for a liquid dielectric transformer (2) enclosed in an airtight tank (3), the device (1) comprising at least one electromechanical safety contactor (11c, 12c, 13b) of which the switching is intended to cause the instantaneous opening of a circuit breaker of the transformer (2), the device (1) comprising:
- a circuit (D) for detecting the switching of the electromechanical contactor (11c, 12c, 13b);
- an electronic measurement unit (17) which is connected to the detection circuit (D) and configured to trace the occurrence of a switching event;
the device being **characterized in that** the detection circuit comprises a current transformer which is configured to measure the current flowing into the electromechanical contactor by detecting a variation in the magnetic field that is likely to occur when the electromechanical contactor switches.

2. Device (1) according to the preceding claim, wherein the electromechanical contactor (11c, 12c, 13b) is included in an electromechanical detector with a temperature, pressure or liquid dielectric level threshold.

3. Device (1) according to either of the preceding claims, wherein the detection circuit (D) comprises components for conditioning a raw detection signal.

4. Device (1) according to any of the preceding claims, wherein the electronic measurement unit (17) comprises an energy storage means.

5. Device (1) according to any of the preceding claims, wherein the electronic measurement unit (17) comprises a communication interface.

6. Device (1) according to any of the preceding claims, comprising at least one circuit for measuring a piece information for monitoring the transformer, the measuring circuit being electrically connected to the electronic measurement unit (17).

7. Device (17) according to the preceding claim, wherein the measurement circuit is a circuit for measuring the level (18, 18a), the temperature or the pressure of the liquid dielectric, a circuit for measuring the magnetic field emitted by windings (4a, 4b) of the transformer (2) or a vibration measurement circuit.

8. Device (1) according to any of the preceding claims, comprising a first internal space (9, 8) in fluid communication with the liquid dielectric of the tank (3) and a second internal space (6, 7) which is separate from the first internal space (9, 8) in which the electromechanical safety contactor (11c, 12c, 13b) and at least one portion of the detection circuit (D) are arranged.

9. Device (1) according to the preceding claim, wherein the electronic measurement unit (17) is arranged in a third internal space (14) of the device (1) which is separate from the first internal space (9, 8) and from the second internal space (6, 7).

10. Method for protecting and monitoring a liquid dielectric transformer (2) enclosed in an airtight tank (3), the method comprising:
- the detection by a detection circuit (D) of a switching event of an electromechanical safety contactor (11c, 12c, 13b) which is intended to cause the instantaneous opening of a circuit breaker of the transformer (2), the detection circuit (D) comprising a current transformer which is configured to measure the current flowing into the electromechanical contactor by detecting a variation in the magnetic field which is likely to occur when the electromechanical contactor switches;
- the tracing, by an electronic measurement unit (17), of the switching event.

11. Method according to the preceding claim, comprising the repetitive measurement and recording in the electronic measurement unit (17) of at least one characteristic of the liquid dielectric or of the windings (4a, 4b) of the transformer (2).

12. Method according to the preceding claim, comprising a step of processing the switching event and measures for establishing and tracing a significant event.

13. Method according to the preceding claim, wherein the processing step comprises erasing, in the electronic measurement unit (17), the data which are not situated in a temporal vicinity of the significant event.
